# EUROPEAN PATENT APPLICATION

(11) **EP 4 739 006 A1**
(43) Date of publication of application: **06.05.2026**
(21) Application number: 24865615.9
(22) Date of filing: 11.06.2024
(51) Int. Cl.: H05K 1/18, H05K 1/02, H05K 1/09

(54) **HYBRID PRINTED CIRCUIT BOARD**

(30) Priority: 11.09.2023 KR 20230120480
(71) Applicant: Samsung Electronics Co., Ltd., Suwon-si, Gyeonggi-do 16677 (KR)
(72) Inventor: KIM, Keonwoo, Suwon-si Gyeonggi-do 16677 (KR); KIM, Moonyoung, Suwon-si Gyeonggi-do 16677 (KR); LEE, Jinhyung, Suwon-si Gyeonggi-do 16677 (KR); KO, Junyoung, Suwon-si Gyeonggi-do 16677 (KR); SEO, Kangmoon, Suwon-si Gyeonggi-do 16677 (KR)
(74) Representative: Gulde & Partner
(86) International application number: PCT/KR2024/007982
(87) International publication number: WO 2025/058170

(57) **Abstract**

A hybrid printed circuit board includes: an insulating substrate; a printed circuit board disposed on an upper surface of the insulating substrate and including at least one through hole in which a surface mount device is accommodated; and an adhesive member provided between the insulating substrate and the printed circuit board.

## Description

### [Technical Field]

The disclosure relates to a printed circuit board, and more particularly to a hybrid printed circuit board.

### [Background Art]

Generally, a display apparatus includes a power board that supplies power to operate the display apparatus.

The power board may be configured to convert alternating current power to direct current power. The power board may include various electronic components for converting alternating current power to direct current power and a printed circuit board on which these electronic components are disposed.

In general, the power board is disposed in the metal chassis of the display apparatus. At this time, for safety reasons, it is required that the leads of the electronic components, the bodies of the electronic components, etc. of the power board be spaced a predetermined distance apart so as not to make electrical contact with the metal chassis.

On the other hand, the trend is to continuously reduce the thickness of the display apparatus. However, the distance between the power board and the metal chassis may be a limiting factor in reducing the thickness of the display apparatus.

Therefore, in order to reduce the thickness of the display apparatus, it is desirable to reduce the separation distance between the power board and the metal chassis.

### [Disclosure of Invention]

### [Technical Solution]

According to one or more embodiments of the disclosure, a hybrid printed circuit board may include: an insulating substrate; a printed circuit board disposed on an upper surface of the insulating substrate and including at least one through hole in which a surface mount device is accommodated; and an adhesive member comprising an adhesive provided between the insulating substrate and the printed circuit board.

According to one or more embodiments of the disclosure, the adhesive member may be formed of no-flow prepreg or bonding sheet.

According to one or more embodiments of the disclosure, the insulating substrate may be formed of any one of FR-1, FR-3, FR-4, CEM-1, and CEM-3.

According to one or more embodiments of the disclosure, a thickness of the insulating substrate may be at least 0.4 mm.

According to one or more embodiments of the disclosure, the printed circuit board may include a base plate; and a copper foil layer formed on at least one of both surfaces of the base plate.

According to one or more embodiments of the disclosure, the base plate of the printed circuit board may be formed of any one of FR-1, FR-3, FR-4, CEM-1, and CEM-3.

According to one or more embodiments of the disclosure, the printed circuit board may include a base plate and a copper foil layer provided on one surface of the base plate. The insulating substrate may be formed of a same insulating material as the base plate.

According to one or more embodiments of the disclosure, the printed circuit board may include a base plate and a copper foil layer provided on one surface of the base plate. The insulating substrate may be formed of an insulating material different from the base plate.

According to one or more embodiments of the disclosure, the printed circuit board may include a base plate and an upper copper foil layer and a lower copper foil layer provided on both surfaces of the base plate. The insulating substrate may be formed of a same insulating material as the base plate.

According to one or more embodiments of the disclosure, the printed circuit board may include a base plate and an upper copper foil layer and a lower copper foil layer provided on both surfaces of the base plate. The insulating substrate may be formed of an insulating material different from the base plate.

According to one or more embodiments of the disclosure, the printed circuit board may include a first printed circuit board and a second printed circuit board that are electrically connected to each other.

According to one or more embodiments of the disclosure, the first printed circuit board may include a first terminal pattern formed on its upper surface. The second printed circuit board may include a second terminal pattern formed on its upper surface to correspond to the first terminal pattern. The printed circuit board may include a connection board that is disposed on upper surfaces of the first terminal pattern and the second terminal pattern and electrically connects the first terminal pattern and the second terminal pattern.

According to one or more embodiments of the disclosure, the connection board may include a connection pattern formed to connect the first terminal pattern and the second terminal pattern.

According to one or more embodiments of the disclosure, the first printed circuit board may be formed as a double-sided printed circuit board, and the second printed circuit board may be formed as a single-sided printed circuit board.

According to one or more embodiments of the disclosure, the hybrid printed circuit board may include a bending prevention reinforcement member disposed on the upper surface of the printed circuit board.

### [Brief Description of Drawings]

These and/or other aspects, features, and advantages of certain embodiments of the disclosure will be more apparent from the following description taken in conjunction with the accompanying drawings, in which:
FIG. 1 is a perspective view illustrating a hybrid printed circuit board according to one or more embodiments of the disclosure.
FIG. 2 is an exploded perspective view illustrating a printed circuit board and an insulating substrate of a hybrid printed circuit board according to one or more embodiments of the disclosure.
FIG. 3 is a side view of a hybrid printed circuit board according to one or more embodiments of the disclosure.
FIG. 4 is a side view of a hybrid printed circuit board according to one or more embodiments of the disclosure.
FIG. 5 is a perspective view illustrating a hybrid printed circuit board according to one or more embodiments of the disclosure.
FIG. 6 is an exploded perspective view illustrating a printed circuit board and an insulating substrate of a hybrid printed circuit board according to one or more embodiments of the disclosure.
FIG. 7 is a side view of a hybrid printed circuit board according to one or more embodiments of the disclosure.
FIG. 8 is a side view of a hybrid printed circuit board according to one or more embodiments of the disclosure.
FIG. 9 is a perspective view illustrating a hybrid printed circuit board according to one or more embodiments of the disclosure.
FIG. 10 is an exploded perspective view illustrating a printed circuit board and an insulating substrate of a hybrid printed circuit board according to one or more embodiments of the disclosure.
FIG. 11 is a side view of a hybrid printed circuit board according to one or more embodiments of the disclosure.
FIG. 12 is a perspective view illustrating a hybrid printed circuit board according to one or more embodiments of the disclosure.
FIG. 13 is a plan view illustrating a first printed circuit board and a second printed circuit board of a hybrid printed circuit board according to one or more embodiments of the disclosure.
FIG. 14 is a bottom perspective view illustrating a connection board of a hybrid printed circuit board according to one or more embodiments of the disclosure.
FIGS. 15A, 15B, and 15C are views for explaining a method of manufacturing a hybrid printed circuit board according to one or more embodiments of the disclosure.
FIG. 16 is a view illustrating a power board using a hybrid printed circuit board according to one or more embodiments of the disclosure disposed on a metal chassis.
FIG. 17 is a view illustrating a power board according to the prior art disposed in a metal chassis.
FIG. 18 is a view illustrating a power board using an SMD printed circuit board disposed on a metal chassis.
FIG. 19 is a perspective view illustrating a state in which a bending prevention reinforcement member is disposed on a hybrid printed circuit board according to one or more embodiments of the disclosure.
FIG. 20 is a perspective view illustrating a state in which a bending prevention reinforcement member is separated from a hybrid printed circuit board according to one or more embodiments of the disclosure.

### [Best Mode for Carrying out the Invention]

Various embodiments of this document and terms used herein are not intended to limit the technical features described in this document to specific embodiments, but should be understood to include various modifications, equivalents, or alternatives of the embodiments.

In connection with the description of the drawings, similar reference numbers may be used for similar or related components.

The singular form of a noun corresponding to an item may include one or more of the above item, unless the relevant context clearly indicates otherwise.

In this document, each of phrases such as "A or B," "at least one of A and B," "at least one of A or B," "A, B, or C," "at least one of A, B, and C," "at least one of A, B, C" may include any one of the items listed together with the corresponding phrase, or any possible combination thereof.

The term "and/or" includes any element of a plurality of related described elements or a combination of a plurality of related described elements.

Terms such as "first," "second," "primary," or "secondary" may be used simply to distinguish one component from other components, and do not limit the corresponding components in other respects (e.g., importance or order).

When it is mentioned that one (e.g., first) component is "coupled" or "connected" to another (e.g., second) component with or without terms "functionally" or "communicatively", it means that the one component can be connected to the another component directly (e.g., wired), wirelessly, or through a third component.

Terms such as "include" or "have" are intended to designate the presence of features, numbers, steps, operations, components, parts, or combinations thereof described in the embodiment, but do not preclude the presence or addition of one or more other features, numbers, steps, operations, components, parts, or combination thereof.

When a component is said to be "connected," "coupled," "supported," or "in contact" with another component, this means not only cases where the components are directly connected, coupled, supported, or contacted, but also cases where the components are indirectly connected, coupled, supported, or contacted through a third component.

When a component is said to be located "on" other component, this includes not only cases where the component is in contact with the other component, but also cases where another component exits between the two components.

Further, the terms 'leading end', 'rear end', 'upper side', 'lower side', 'top end', 'bottom end', etc. used in the disclosure are defined with reference to the drawings. However, the shape and position of each component are not limited by the terms.

The disclosure relates a hybrid printed circuit board 1 that may reduce the separation distance between a power board and a metal chassis.

Hereinafter, a hybrid printed circuit board 1 according to one or more embodiments of the disclosure will be described in detail with reference to the attached drawings.

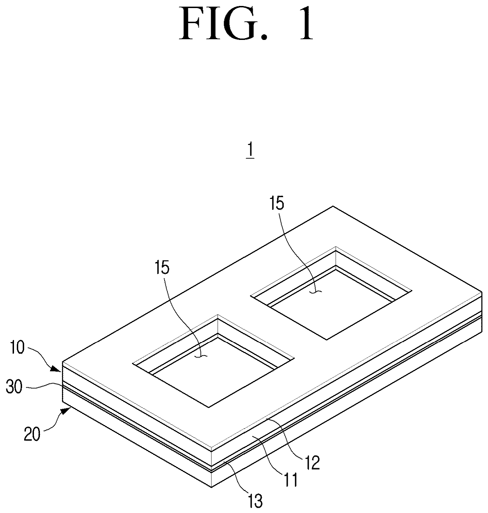

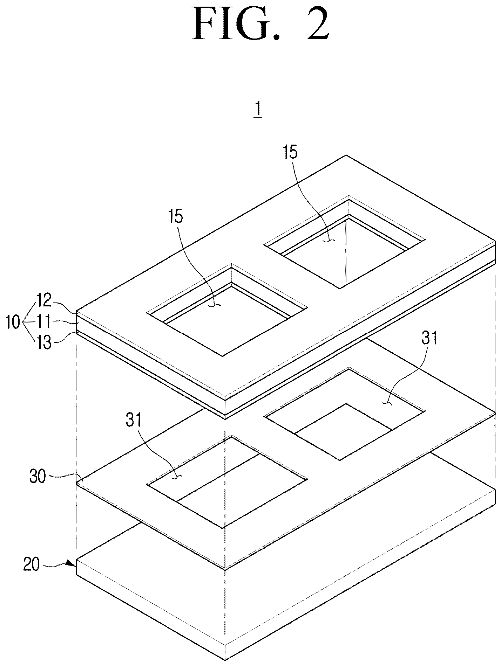

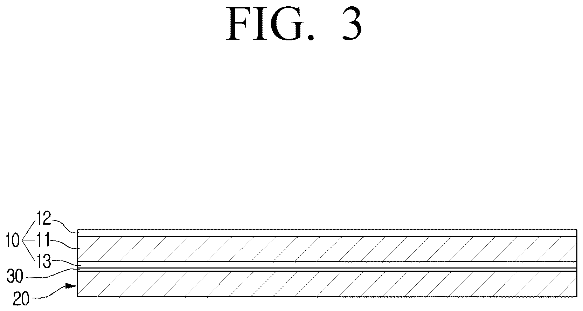

FIG. 1 is a perspective view illustrating a hybrid printed circuit board 1 according to one or more embodiments of the disclosure. FIG. 2 is an exploded perspective view illustrating a printed circuit board 10 and an insulating substrate 20 of a hybrid printed circuit board 1 according to one or more embodiments of the disclosure. FIG. 3 is a side view of a hybrid printed circuit board 1 according to one or more embodiments of the disclosure.

Referring to FIGS. 1, 2, and 3, a hybrid printed circuit board 1 according to one or more embodiments of the disclosure includes a printed circuit board 10 and an insulating substrate 20.

The printed circuit board 10 is formed in a flat shape and includes a base plate 11 and two copper foil layers 12 and 13.

The two copper foil layers 12 and 13 are formed on the upper and lower surfaces of the base plate 11. The base plate 11 is made of an insulating material. In other words, the printed circuit board 10 may be formed as a double-sided printed circuit board. Alternatively, the printed circuit board 10 may be formed as a multilayer board.

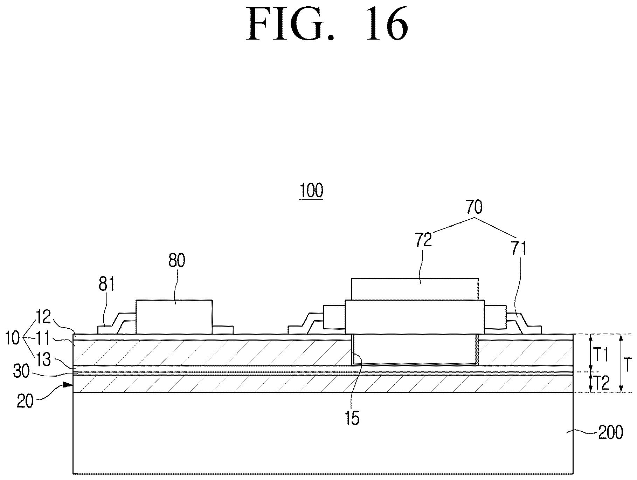

The printed circuit board 10 may include at least one through hole 15. The at least one through hole 15 may be formed to penetrate the printed circuit board 10 vertically. The at least one through hole 15 may be formed to accommodate a surface mount device. In other words, the at least one through hole 15 may be formed with an area corresponding to the size of the surface mount device to be accommodated. For example, as illustrated in FIG. 16, when disposing the surface mount device 70 on the upper surface of the printed circuit board, the through hole 15 may be formed so that the lower portion of the body 72 of the surface mount device 70 is accommodated in the through hole 15.

In this embodiment, two through holes 15 are formed in the printed circuit board 10, but this is only an example. The number of through hole 15 is not limited to this. As another example, one through hole 15 or three or more through holes 15 may be formed in the printed circuit board 10 depending on the number of surface mount devices used. A transformer, a capacitor, etc. may be disposed in the through hole 15.

In this way, when the through hole 15 is formed in the printed circuit board 10 and the surface mount device is disposed in the through hole 15, the height from the upper surface of the printed circuit board 10 to the top of the surface mount device may be reduced. In other words, the height of a power board 100 (see FIG. 16) using the hybrid printed circuit board 1 according to one or more embodiments of the disclosure may be reduced.

The printed circuit board 10 may be formed of FR-4. That is, the base plate 11 may be formed of FR-4 material, and the copper foil layers 12 and 13 may be formed of copper (Cu). Here, FR stands for Flame Retardant. FR-4 may be formed by stacking several layers of sheets formed by combining glass fiber with epoxy resin and drying them, and then subjecting them to high-temperature/ high-pressure treatment. FR-4 has insulating properties.

The insulating substrate 20 is disposed on the lower surface of the printed circuit board 10. In other words, the insulating substrate 20 is disposed below a lower copper foil layer 13 of the printed circuit board 10. The insulating substrate 20 is made of an insulating material. In this embodiment, the insulating substrate 20 is made of the same material as the base plate 11 of the printed circuit board 10. That is, the insulating substrate 20 may be formed of FR-4 material.

The insulating substrate 20 may be formed to have the same shape and size as the printed circuit board 10.

The thickness of the insulating substrate 20 may be defined so that the metal chassis and electronic components disposed on the printed circuit board 10 may be insulated from each other. According to safety standards (e.g., IEC62368-1), when the printed circuit board 10 satisfies the creepage distance, the thickness of the insulating substrate 20 may be 0.4 mm or more.

The insulating substrate 20 may be formed to have a thinner thickness than the printed circuit board 10.

The insulating substrate 20 may be attached to the printed circuit board 10 using an adhesive member (e.g., including an adhesive material) 30. In other words, the adhesive member 30 may be provided between the insulating substrate 20 and the printed circuit board 10. In detail, the insulating substrate 20 may be attached to the lower copper foil layer 13 of the printed circuit board 10 by the adhesive member 30.

When the adhesive member 30 is interposed between the insulating substrate 20 and the printed circuit board 10 and pressure is applied to the insulating substrate 20 and the printed circuit board 10, the insulating substrate 20 and the printed circuit board 10 may be bonded with each other.

The adhesive member 30 may include at least one through hole 31 corresponding to the at least one through hole 15 formed in the printed circuit board 10.

The adhesive member 30 may be made of a material that has insulating properties and can bond the printed circuit board 10 and the insulating substrate 20.

For example, no-flow prepreg may be used as the adhesive member 30. By interposing the no-flow prepreg between the lower surface of the printed circuit board 10 and the insulating substrate 20, the insulating substrate 20 may be attached to the printed circuit board 10. At this time, the portion of the no-flow prepreg corresponding to the at least one through hole 15 may be removed so that the no-flow prepreg does not exist in the lower side of the at least one through hole 15 of the printed circuit board 10.

The no-flow prepreg has a lower spreading thickness than general prepreg. For example, the spreading thickness of no-flow prepreg is 50 µm or less, and the spreading thickness of general prepreg is about 200 µm. The general prepreg may be used for adhesion of the printed circuit board 10 and the insulating substrate 20.

Therefore, when the hybrid printed circuit board 1 is formed by attaching the printed circuit board 10 to the upper surface of the insulating substrate 20 using the no-flow prepreg, the thickness of the hybrid printed circuit board 1 may be made thinner than when using the general prepreg.

As another example, a bonding sheet may be used as the adhesive member 30. By interposing the bonding sheet between the lower surface of the printed circuit board 10 and the insulating substrate 20, the printed circuit board 10 and the insulating substrate 20 may be bonded to each other. At this time, the portion of the bonding sheet corresponding to the at least one through hole 15 may be removed so that the bonding sheet does not exist below the at least one through hole 15 of the printed circuit board 10.

The bonding sheet has an initial viscosity similar to double-sided tape, allowing temporary bonding of the printed circuit board 10 and the insulating substrate 20. Thereafter, when the bonding sheet is cured by applying heat, the bonding sheet bonds and fixes the printed circuit board 10 and the insulating substrate 20 to form a hybrid printed circuit board 1.

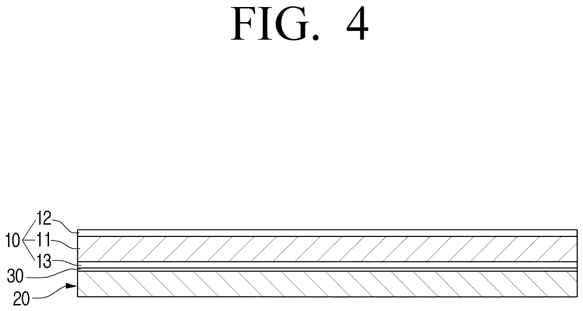

In the above description, the base plate 11 of the printed circuit board 10 and the insulating substrate 20 are formed of the same material. However, the hybrid printed circuit board 1 according to one or more embodiments of the disclosure is not limited thereto. As illustrated in FIG. 4, the base plate 11 of the printed circuit board 10 and the insulating substrate 20 may be formed of different materials.

FIG. 4 is a side view of a hybrid printed circuit board 1 according to one or more embodiments of the disclosure.

Referring to FIG. 4, a hybrid printed circuit board 1 according to one or more embodiments of the disclosure includes a printed circuit board 10 and an insulating substrate 20.

The printed circuit board 10 is formed in a flat shape and includes a base plate 11 and two copper foil layers 12 and 13.

The two copper foil layers 12 and 13 are formed on the upper and lower surfaces of the base plate 11. The base plate 11 is made of an insulating material. In other words, the printed circuit board 10 may be formed as a double-sided printed circuit board.

The printed circuit board 10 may include at least one through hole 15. The at least one through hole 15 may be formed to penetrate the printed circuit board 10 vertically. The at least one through hole 15 may be formed to accommodate a surface mount device. In other words, the at least one through hole 15 may be formed with an area corresponding to the size of the surface mount device to be accommodated therein.

The printed circuit board 10 may be formed of FR-4. That is, the base plate 11 may be formed of FR-4 material, and the copper foil layers 12 and 13 may be formed of copper (Cu).

The insulating substrate 20 is disposed on the lower surface of the printed circuit board 10. In other words, the insulating substrate 20 is disposed below a lower copper foil layer 13 of the printed circuit board 10. The insulating substrate 20 is made of an insulating material. In this embodiment, the insulating substrate 20 is made of a material different from the base plate 11 of the printed circuit board 10.

For example, the insulating substrate 20 may be formed of any one of FR-1, FR-3, CEM-1, and CEM-3 materials. In detail, FR-1 may be formed by stacking multiple sheets formed by combining paper with phenol resin and drying it. FR-3 may be formed by stacking multiple sheets formed by combining paper with epoxy resin and drying it. CEM-1 is a composite material including a woven glass fiber surface and a paper core combined with epoxy resin. CEM-3 is a composite material including a woven glass fiber surface and a non-woven glass fiber core combined with epoxy resin. Here, CEM stands for composite epoxy material.

The insulating substrate 20 may be formed to have the same shape and size as the printed circuit board 10.

The thickness of the insulating substrate 20 may be defined so that the metal chassis and electronic components disposed on the printed circuit board 10 may be insulated from each other. According to safety standards (e.g., IEC62368-1), when the printed circuit board 10 satisfies the creepage distance, the insulating substrate 20 may be formed to have a thickness of 0.4 mm or more.

The insulating substrate 20 may be formed to have a thinner thickness than the printed circuit board 10.

The insulating substrate 20 may be attached to the printed circuit board 10 using an adhesive member 30. In other words, the adhesive member 30 may be provided between the insulating substrate 20 and the printed circuit board 10. In detail, the insulating substrate 20 may be attached to the lower copper foil layer 13 of the printed circuit board 10 by the adhesive member 30.

The no-flow prepreg or bonding sheet described above may be used as the adhesive member 30.

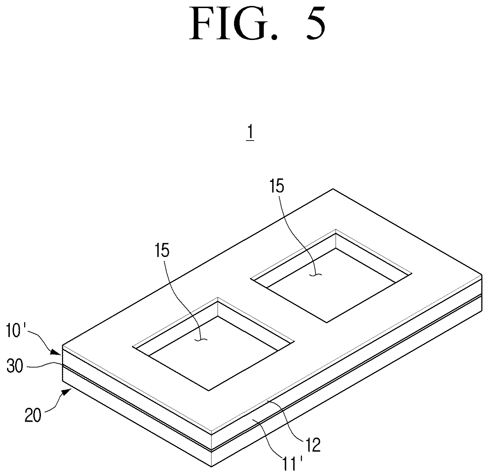

In the above description, a double-sided printed circuit board is used as the printed circuit board 10. However, the hybrid printed circuit board 1 according to one or more embodiments of the disclosure is not limited thereto. As illustrated in FIGS. 5, 6, and 7, a single-sided printed circuit board may be used as the printed circuit board 10.

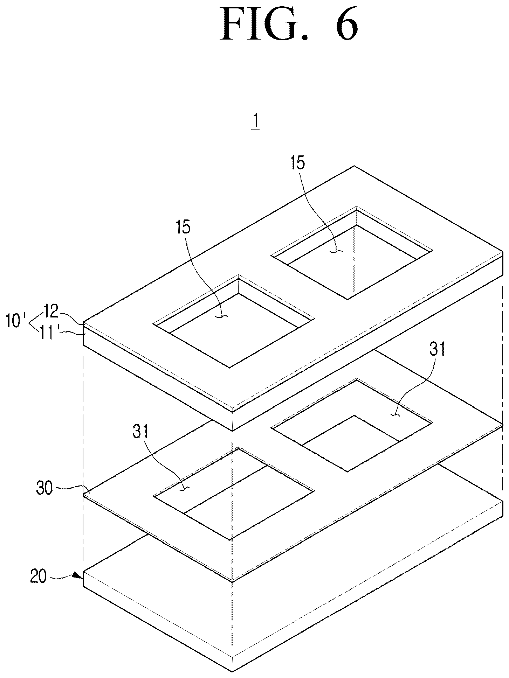

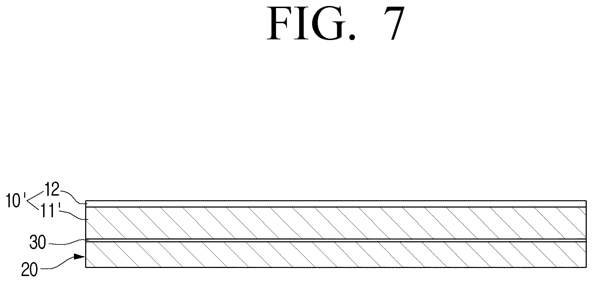

FIG. 5 is a perspective view illustrating a hybrid printed circuit board 1 according to one or more embodiments of the disclosure. FIG. 6 is an exploded perspective view illustrating a printed circuit board 10' and an insulating substrate 20 of a hybrid printed circuit board 1 according to one or more embodiments of the disclosure. FIG. 7 is a side view illustrating a hybrid printed circuit board 1 according to one or more embodiments of the disclosure.

Referring to FIGS. 5, 6, and 7, a hybrid printed circuit board 1 according to one or more embodiments of the disclosure includes a printed circuit board 10' and an insulating substrate 20.

The printed circuit board 10' is formed in a flat shape and includes a base plate 11 and a copper foil layer 12. The copper foil layer 12 is formed on the upper surface of the base plate 11. The base plate 11 is made of an insulating material. In other words, the printed circuit board 10' may be formed as a single-sided printed circuit board.

The printed circuit board 10' may include at least one through hole 15. The at least one through hole 15 may be formed to penetrate the printed circuit board 10' vertically. The at least one through hole 15 may be formed to accommodate a surface mount device. In other words, the at least one through hole 15 may be formed with an area corresponding to the size of the surface mount device to be accommodated therein. For example, as illustrated in FIG. 16, when disposing the surface mount device 70 on the upper surface of the printed circuit board 10', the through hole 15 may be formed so that the lower portion of the body 72 of the surface mount device 70 is accommodated in the through hole 15.

In this embodiment, two through holes 15 are formed in the printed circuit board 10', but this is only an example. The number of through holes 15 is not limited to this. As another example, one through hole 15 or three or more through holes 15 may be formed in the printed circuit board 10' depending on the number of surface mount devices used. A transformer, a capacitor, etc. may be disposed in the through hole 15.

In this way, when the through hole 15 is formed in the printed circuit board 10' and the surface mount device is disposed in the through hole 15, the height from the upper surface of the printed circuit board 10' to the top of the surface mount device may be reduced. In other words, the height of a power board using the hybrid printed circuit board 1 according to one or more embodiments of the disclosure may be reduced.

The printed circuit board 10' may be formed of FR-1. That is, the base plate 11 may be formed of FR-1 material, and the copper foil layer 12 may be formed of copper (Cu). FR-1 has insulating properties.

Alternatively, the base plate 11 may be formed of any one of FR-3, CEM-1, and CEM-3 materials instead of FR-1.

The insulating substrate 20 is disposed on the lower surface of the printed circuit board 10'. In other words, the insulating substrate 20 is disposed below the base plate 11 of the printed circuit board 10'. The insulating substrate 20 is made of an insulating material. In this embodiment, the insulating substrate 20 is made of the same material as the base plate 11 of the printed circuit board 10'. That is, the insulating substrate 20 may be formed of FR-1 material.

When the base plate 11 is made of any one of FR-3, CEM-1, and CEM-3 materials, the insulating substrate 20 may be made of any one of FR-3, CEM-1, and CEM-3 materials in the same way as the base plate 11.

The insulating substrate 20 may be formed to have the same shape and size as the printed circuit board 10'.

The thickness of the insulating substrate 20 may be defined so that the metal chassis and electronic components disposed on the printed circuit board 10' may be insulated from each other. According to safety standards (e.g., IEC62368-1), when the printed circuit board 10' satisfies the creepage distance, the insulating substrate 20 may be formed to have a thickness of 0.4 mm or more.

The insulating substrate 20 may be formed to have a thinner thickness than the printed circuit board 10'.

The insulating substrate 20 may be attached to the printed circuit board 10' using an adhesive member 30. In other words, the adhesive member 30 may be provided between the insulating substrate 20 and the printed circuit board 10'. In detail, the insulating substrate 20 may be attached to the lower surface of the base plate 11 of the printed circuit board 10' by the adhesive member 30.

The adhesive member 30 may be made of a material that has insulating properties and can bond the printed circuit board 10' and the insulating substrate 20. The no-flow prepreg or bonding sheet described above may be used as the adhesive member 30.

The adhesive member 30 may include at least one through hole 31 corresponding to the at least one through hole 15 formed in the printed circuit board 10'.

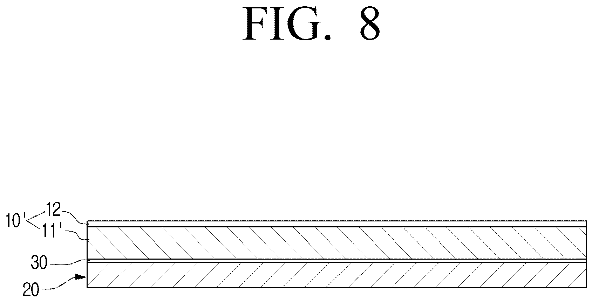

In the embodiment of FIGS. 5, 6, and 7, the base plate 11 of the printed circuit board 10' and the insulating substrate 20 are formed of the same material. However, the hybrid printed circuit board 1 according to one or more embodiments of the disclosure is not limited thereto. As illustrated in FIG. 8, the base plate 11 of the printed circuit board 10' and the insulating substrate 20 may be formed of different materials.

FIG. 8 is a side view of a hybrid printed circuit board according to one or more embodiments of the disclosure.

Referring to FIG. 8, a hybrid printed circuit board 1 according to one or more embodiments of the disclosure includes a printed circuit board 10' and an insulating substrate 20.

The printed circuit board 10' is formed in a flat shape and includes a base plate 11 and a copper foil layer 12. The copper foil layer 12 is formed on the upper surface of the base plate 11. The base plate 11 is made of an insulating material. In other words, the printed circuit board 10' may be formed as a single-sided printed circuit board.

The printed circuit board 10' may include at least one through hole 15. The at least one through hole 15 may be formed to penetrate the printed circuit board 10' vertically. The at least one through hole 15 may be formed to accommodate a surface mount device. In other words, the at least one through hole 15 may be formed with an area corresponding to the size of the surface mount device to be accommodated therein.

The printed circuit board 10' may be formed of FR-1. That is, the base plate 11 may be formed of FR-1 material, and the copper foil layer 12 may be formed of copper (Cu).

The insulating substrate 20 is disposed on the lower surface of the printed circuit board 10'. In other words, the insulating substrate 20 is disposed on a lower surface of the base plate 11 of the printed circuit board 10'. The insulating substrate 20 is made of an insulating material. In this embodiment, the insulating substrate 20 is made of a material different from the base plate 11 of the printed circuit board 10'.

For example, the insulating substrate 20 may be formed of any one of the insulating materials selected from FR-3, FR-4, CEM-1, and CEM-3, excluding FR-1.

The insulating substrate 20 may be formed to have the same shape and size as the printed circuit board 10'.

The thickness of the insulating substrate 20 may be defined so that the metal chassis and electronic components disposed on the printed circuit board 10' may be insulated from each other. According to safety standards (e.g., IEC62368-1), when the printed circuit board 10' satisfies the creepage distance, the insulating substrate 20 may be formed to have a thickness of 0.4 mm or more.

The insulating substrate 20 may be formed to have a thinner thickness than the printed circuit board 10'.

The insulating substrate 20 may be attached to the printed circuit board 10' using an adhesive member 30. In other words, the adhesive member 30 may be provided between the insulating substrate 20 and the printed circuit board 10'. In detail, the insulating substrate 20 may be attached to the lower surface of the base plate 11 of the printed circuit board 10' by the adhesive member 30.

The no-flow prepreg or bonding sheet described above may be used as the adhesive member 30.

The hybrid printed circuit board 1 described above is formed of one printed circuit board 10' and one insulating substrate 20. However, the hybrid printed circuit board 1 according to one or more embodiments of the disclosure is not limited thereto.

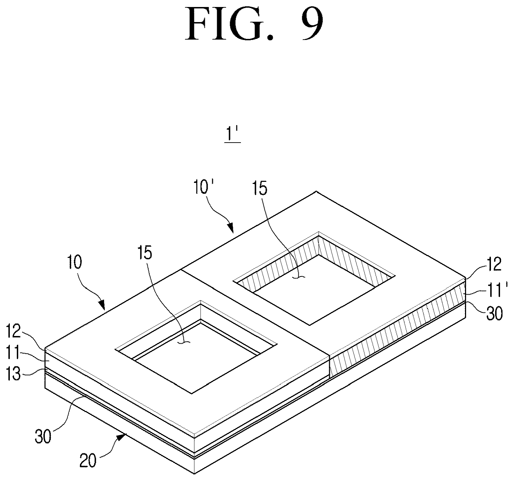

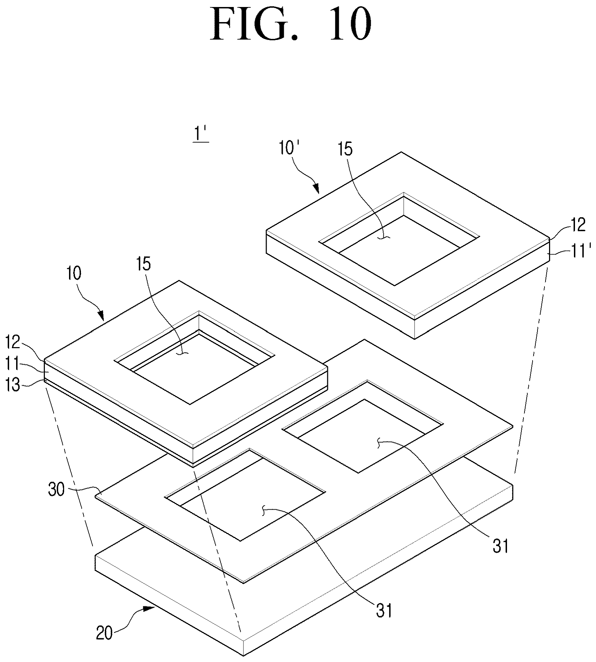

As another example, a hybrid printed circuit board 1'according to one or more embodiments of the disclosure may be formed of two printed circuit boards 10 and one insulating substrate 20, as illustrated in FIGS. 9 and 10.

FIG. 9 is a perspective view illustrating a hybrid printed circuit board 1' according to one or more embodiments of the disclosure. FIG. 10 is an exploded perspective view illustrating printed circuit boards 10 and 10' and an insulating substrate 20 of a hybrid printed circuit board 1' according to one or more embodiments of the disclosure.

Referring to FIGS. 9 and 10, a hybrid printed circuit board 1' according to one or more embodiments of the disclosure includes a first printed circuit board 10, a second printed circuit board 10', and an insulating substrate 20.

The first printed circuit board 10 is formed in a flat shape and includes a first base plate 11 and two copper foil layers 12 and 13. The two copper foil layers 12 and 13 are formed on the upper and lower surfaces of the first base plate 11. The first base plate 11 is made of an insulating material. In other words, the first printed circuit board 10 may be formed as a double-sided printed circuit board.

The first printed circuit board 10 may include at least one through hole 15. The at least one through hole 15 may be formed to penetrate the first printed circuit board 10 vertically. The at least one through hole 15 may be formed to accommodate a surface mount device. In other words, the at least one through hole 15 may be formed with an area corresponding to the size of the surface mount device to be accommodated.

The first printed circuit board 10 may be formed of FR-4. That is, the first base plate 11 may be formed of FR-4 material, and the copper foil layers 12 and 13 may be formed of copper (Cu). FR-4 has insulating properties.

The second printed circuit board 10' is formed separately from the first printed circuit board 10. The second printed circuit board 10' is formed in a flat shape and includes a second base plate 11' and a copper foil layer 12. The copper foil layer 12 is formed on the upper surface of the second base plate 11'. The second base plate 11' is made of an insulating material. In other words, the second printed circuit board 10' may be formed as a single-sided printed circuit board.

The second printed circuit board 10' is formed to have the same thickness as the first printed circuit board 10. When the thickness of the upper copper foil layer 12 of the first printed circuit board 10 is equal to the thickness of the copper foil layer 12 of the second printed circuit board 10', the second base plate 11' is formed to be thicker than the thickness of the first base plate 11.

The second printed circuit board 10' may include at least one through hole 15. The at least one through hole 15 may be formed to penetrate the second printed circuit board 10' vertically. The at least one through hole 15 may be formed to accommodate a surface mount device. In other words, the at least one through hole 15 may be formed with an area corresponding to the size of the surface mount device to be accommodated.

Because the second printed circuit board 10' is a single-sided printed circuit board, it may be formed of a different material from the first printed circuit board 10, which is a double-sided printed circuit board. In other words, the second printed circuit board 10' may be formed of FR-1. In detail, the second base plate 11' may be formed of FR-1 material, and the copper foil layer 12 may be formed of copper (Cu). FR-1 has insulating properties.

Alternatively, the second base plate 11' may be formed of any one of FR-3, CEM-1, and CEM-3 materials instead of FR-1.

The insulating substrate 20 is disposed on the lower surfaces of the first printed circuit board 10 and the second printed circuit board 10'. In other words, the first printed circuit board 10 and the second printed circuit board 10' are disposed on the upper surface of the insulating substrate 20. Accordingly, the lower copper foil layer 13 of the first printed circuit board 10 and the second base plate 11' of the second printed circuit board 10' are adjacent to the upper surface of the insulating substrate 20.

The insulating substrate 20 is made of an insulating material. In this embodiment, the insulating substrate 20 is made of an insulating material that is the same as the first base plate 11 of the first printed circuit board 10 and is different from the second base plate 11' of the second printed circuit board 10'. That is, the insulating substrate 20 may be formed of FR-4 material.

The insulating substrate 20 may be formed to have a shape and size corresponding to the first printed circuit board 10 and the second printed circuit board 10'.

The thickness of the insulating substrate 20 may be defined so that the metal chassis and electronic components disposed on the first and second printed circuit boards 10 and 10' may be insulated from each other. According to safety standards (e.g., IEC62368-1), when the first printed circuit board 10 and the second printed circuit board 10' satisfy the creepage distance, the insulating substrate 20 may be formed to have a thickness of 0.4 mm or more.

The insulating substrate 20 may be formed to have a thinner thickness than the first printed circuit board 10 and the second printed circuit board 10'.

The first printed circuit board 10 and the second printed circuit board 10' may be attached to the insulating substrate 20 using an adhesive member 30. In other words, the adhesive member 30 may be provided between the insulating substrate 20 and the first and second printed circuit boards 10 and 10'. In detail, the insulating substrate 20 may be attached to the lower copper foil layer 13 of the first printed circuit board 10 and the lower surface of the second base plate 11' of the printed circuit board 10' by the adhesive member 30.

The adhesive member 30 may be made of a material that has insulating properties and can bond the first and second printed circuit boards 10 and 10' and the insulating substrate 20.

For example, the no-flow prepreg or bonding sheet described above may be used as the adhesive member 30.

The adhesive member 30 may include two through holes 31 corresponding to the through hole 15 formed in the first printed circuit board 10 and the through hole 15 formed in the second printed circuit board 10'.

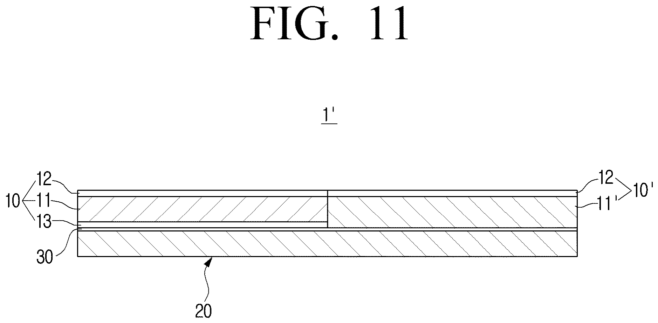

In the embodiment of FIGS. 9 and 10 as described above, the first base plate 11 of the first printed circuit board 10 is formed of the same material as the insulating substrate 20. However, the hybrid printed circuit board 1' according to one or more embodiments of the disclosure is not limited thereto. As illustrated in FIG. 11, the insulating substrate 20 may be formed of the same material as the second base plate 11' of the second printed circuit board 10'.

FIG. 11 is a side view of a hybrid printed circuit board 1' according to one or more embodiments of the disclosure.

Referring to FIG. 11, a hybrid printed circuit board 1' according to one or more embodiments of the disclosure includes a first printed circuit board 10, a second printed circuit board 10', and an insulating substrate 20.

The first printed circuit board 10 and the second printed circuit board 10' are the same as those of the embodiment shown in FIGS. 9 and 10. Therefore, detailed descriptions thereof are omitted.

The insulating substrate 20 is disposed on the lower surfaces of the first printed circuit board 10 and the second printed circuit board 10'. In other words, the first printed circuit board 10 and the second printed circuit board 10' are disposed on the upper surface of the insulating substrate 20. Accordingly, the lower copper foil layer 13 of the first printed circuit board 10 and the second base plate 11' of the second printed circuit board 10' are adjacent to the upper surface of the insulating substrate 20.

The insulating substrate 20 is made of an insulating material. In this embodiment, the insulating substrate 20 is made of an insulating material that is the same as the second base plate 11' of the second printed circuit board 10' and is different from the first base plate 11 of the first printed circuit board 10. That is, the insulating substrate 20 may be formed of FR-1 material.

When the second base plate 11' is formed of any one of FR-3, CEM-1, and CEM-3 materials instead of FR-1, the insulating substrate 20 may be made of any one of FR-3, CEM-1, and CEM-3, the same material as the second base plate 11'.

Other than the material, the insulating substrate 20 has the same characteristics as the insulating substrate 20 of the embodiment shown in FIGS. 9 and 10 described above. Therefore, detailed description thereof is omitted.

The first printed circuit board 10 and the second printed circuit board 10' may be attached to the insulating substrate 20 using an adhesive member 30. In other words, the adhesive member 30 may be provided between the insulating substrate 20 and the first and second printed circuit boards 10 and 10'. In detail, the insulating substrate 20 may be attached to the lower copper foil layer 13 of the first printed circuit board 10 and the lower surface of the second base plate 11' of the printed circuit board 10' by the adhesive member 30.

The adhesive member 30 is the same as the adhesive member 30 of the embodiment shown in FIGS. 9 and 10. Therefore, detailed description thereof is omitted.

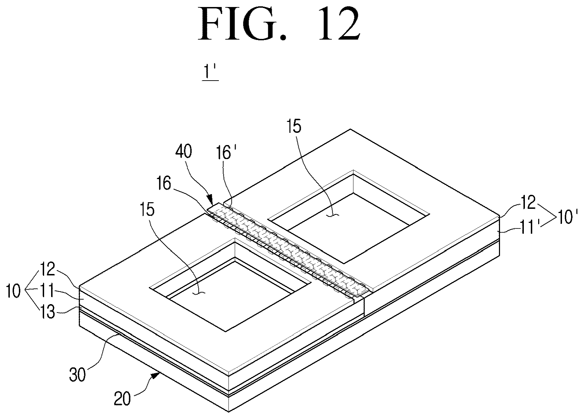

The two printed circuit boards 10 and 10' may be electrically connected to each other using a connection board 40. Hereinafter, a hybrid printed circuit board 1' according to one or more embodiments of the disclosure having this structure will be described with reference to FIGS. 12, 13, and 14.

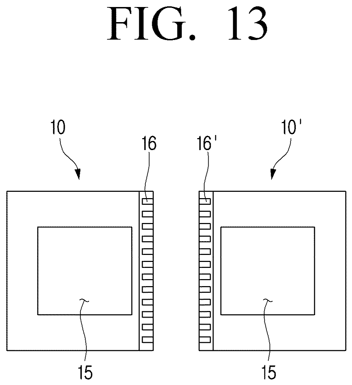

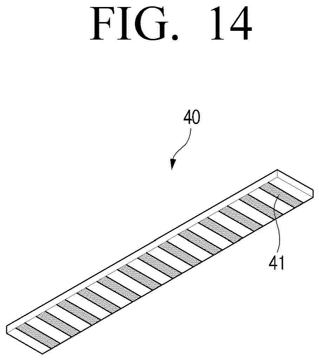

FIG. 12 is a perspective view illustrating a hybrid printed circuit board 1' according to one or more embodiments of the disclosure. FIG. 13 is a plan view illustrating a first printed circuit board 10 and a second printed circuit board 10' of a hybrid printed circuit board 1' according to one or more embodiments of the disclosure. FIG. 14 is a bottom perspective view illustrating a connection board 40 of a hybrid printed circuit board 1' according to one or more embodiments of the disclosure.

Referring to FIG. 12, a hybrid printed circuit board 1' according to one or more embodiments of the disclosure includes a first printed circuit board 10, a second printed circuit board 10', an insulating substrate 20, and a connection board 40.

The first printed circuit board 10 is formed in a flat shape and includes a first base plate 11 and two copper foil layers 12 and 13. The two copper foil layers 12 and 13 are formed on the upper and lower surfaces of the first base plate 11. That is, the first printed circuit board 10 includes an upper copper foil layer 12 and a lower copper foil layer 13. The first base plate 11 is made of an insulating material. In other words, the first printed circuit board 10 may be formed as a double-sided printed circuit board.

The first printed circuit board 10 may include at least one through hole 15. The at least one through hole 15 may be formed to penetrate the first printed circuit board 10 vertically. The at least one through hole 15 may be formed to accommodate a surface mount device. In other words, the at least one through hole 15 may be formed with an area corresponding to the size of the surface mount device to be accommodated therein.

The first printed circuit board 10 may include a first terminal pattern 16 formed on the upper surface of the first printed circuit board 10. In other words, the first terminal pattern 16 may be formed on the upper copper foil layer 12 of the first printed circuit board 10. The first terminal pattern 16 may be formed to contact one side surface of the first printed circuit board 10. When forming an electronic circuit on the upper copper foil layer 12, the first terminal pattern 16 may be formed using the same method as the method for forming the electronic circuit.

The first terminal pattern 16 may include a plurality of terminals. The plurality of terminals may be formed at regular intervals along the side surface of the first printed circuit board 10. The first terminal pattern 16 may be connected to the electronic circuit formed on the upper copper foil layer 12.

The first printed circuit board 10 may be formed of FR-4. That is, the first base plate 11 may be formed of FR-4 material, and the upper and lower copper foil layers 12 and 13 may be formed of copper (Cu). FR-4 has insulating properties.

The second printed circuit board 10' is formed in a flat shape and includes a second base plate 11' and a copper foil layer 12. The copper foil layer 12 is formed on the upper surface of the second base plate 11'. The second base plate 11' is made of an insulating material. In other words, the second printed circuit board 10' may be formed as a single-sided printed circuit board.

The second printed circuit board 10' is formed to have the same thickness as the first printed circuit board 10. When the thickness of the upper copper foil layer 12 of the first printed circuit board 10 is equal to the thickness of the copper foil layer 12 of the second printed circuit board 10', the second base plate 11' is formed to be thicker than the thickness of the first base plate 11.

The second printed circuit board 10' may include at least one through hole 15. The at least one through hole 15 may be formed to penetrate the second printed circuit board 10' vertically. The at least one through hole 15 may be formed to accommodate a surface mount device. In other words, the at least one through hole 15 may be formed with an area corresponding to the size of the surface mount device to be accommodated therein.

The second printed circuit board 10' may include a second terminal pattern 16' formed on the upper surface of the second printed circuit board 10'. In other words, the second terminal pattern 16' may be formed on the copper foil layer 12 of the second printed circuit board 10'. The second terminal pattern 16' may be formed to correspond to the first terminal pattern 16 of the first printed circuit board 10. The second terminal pattern 16' may be formed to contact one side surface of the second printed circuit board 10'. When forming an electronic circuit on the copper foil layer 12, the second terminal pattern 16' may be formed using the same method as the method for forming the electronic circuit.

The second terminal pattern 16' may include a plurality of terminals. The plurality of terminals may be formed at regular intervals along the side surface of the second printed circuit board 10'. The second terminal pattern 16' may be connected to the electronic circuit formed on the copper foil layer 12.

Because the second printed circuit board 10' is a single-sided printed circuit board, it may be formed of a different material from the first printed circuit board 10, which is a double-sided printed circuit board. In other words, the second printed circuit board 10' may be formed of FR-1. In detail, the second base plate 11' may be formed of FR-1 material, and the copper foil layer 12 may be formed of copper (Cu). FR-1 has insulating properties.

Alternatively, the second base plate 11' may be formed of any one of FR-3, CEM-1, and CEM-3 materials instead of FR-1.

The insulating substrate 20 is disposed on the lower surfaces of the first printed circuit board 10 and the second printed circuit board 10'. In other words, the first printed circuit board 10 and the second printed circuit board 10' are disposed on the upper surface of the insulating substrate 20. Accordingly, the lower copper foil layer 13 of the first printed circuit board 10 and the second base plate 11' of the second printed circuit board 10' are adjacent to the upper surface of the insulating substrate 20.

The insulating substrate 20 is made of an insulating material. In this embodiment, the insulating substrate 20 is made of an insulating material that is the same as the first base plate 11 of the first printed circuit board 10 and is different from the second base plate 11' of the second printed circuit board 10'. That is, the insulating substrate 20 may be formed of FR-4 material.

As another example, the insulating substrate 20 may be made of an insulating material that is the same as the second base plate 11' of the second printed circuit board 10' and is different from the first base plate 11 of the first printed circuit board 10.

The insulating substrate 20 may be formed to have a shape and size corresponding to the first printed circuit board 10 and the second printed circuit board 10'.

The thickness of the insulating substrate 20 may be defined so that the metal chassis and electronic components disposed on the first and second printed circuit boards 10 and 10' may be insulated from each other. According to safety standards (e.g., IEC62368-1), when the first printed circuit board 10 and the second printed circuit board 10' satisfy the creepage distance, the insulating substrate 20 may be formed to have a thickness of 0.4 mm or more.

The insulating substrate 20 may be formed to have a thinner thickness than the first printed circuit board 10 and the second printed circuit board 10'.

The first printed circuit board 10 and the second printed circuit board 10' may be attached to the insulating substrate 20 using an adhesive member 30. In other words, the adhesive member 30 may be provided between the insulating substrate 20 and the first and second printed circuit boards 10 and 10'. In detail, the insulating substrate 20 may be attached to the lower copper foil layer 13 of the first printed circuit board 10 and the lower surface of the second base plate 11' of the printed circuit board 10' by the adhesive member 30.

The adhesive member 30 may be made of a material that has insulating properties and can bond the first and second printed circuit boards 10 and 10' and the insulating substrate 20. For example, the no-flow prepreg or bonding sheet described above may be used as the adhesive member 30.

The connection board 40 is disposed on the upper surfaces of the first terminal pattern 16 and the second terminal pattern 16'. The connection board 40 is formed to connect the first terminal pattern 16 and the second terminal pattern 16'. To this end, the connection board 40 may include a connection pattern 41 connecting the first terminal pattern 16 and the second terminal pattern 16'.

The connection pattern 41 may be formed on the lower surface of the connection board 40. The connection pattern 41 may be formed as a plurality of connection terminals spaced apart at regular intervals. The plurality of connection terminals may be formed of a copper foil layer. The plurality of connection terminals are formed to correspond to the plurality of terminals of the first and second printed circuit boards 10 and 10'.

Therefore, when the connection board 40 is placed on the first terminal pattern 16 of the first printed circuit board 10 and the second terminal pattern 16' of the second printed circuit board 10', the plurality of connection terminals of the connection pattern 41 of the connection board 40 are located on the plurality of terminals of the first terminal pattern 16 and the plurality of terminals of the second terminal pattern 16', thereby electrically connecting the first terminal pattern 16 and the second terminal pattern 16'. At this time, for stable electrical connection, the connection pattern 41 of the connection board 40 may be bonded to the first terminal pattern 16 and the second terminal pattern 16' with lead.

As described above, using the connection board 40, the first printed circuit board 10 and the second printed circuit board 10' may be electrically connected to each other. Therefore, because there is no need to use a connector to connect the first printed circuit board 10 and the second printed circuit board 10', the height of the connected portion may be lowered and material costs may be reduced.

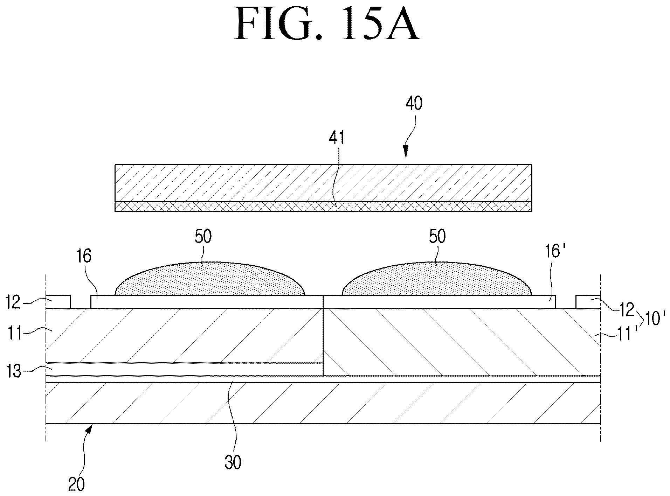

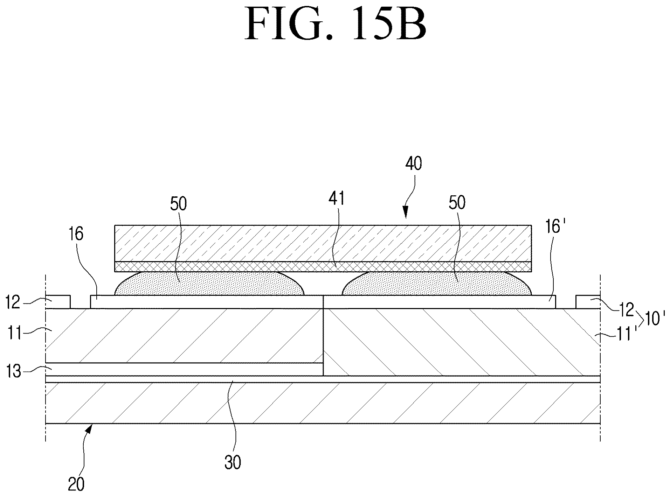

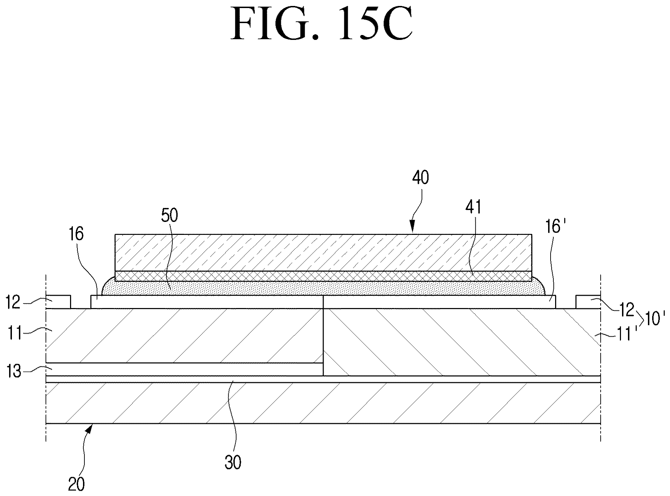

Hereinafter, a method of manufacturing the hybrid printed circuit board 1' according to one or more embodiments of the disclosure shown in FIG. 12 will be described with reference to FIGS. 15A, 15B, and 15C.

FIGS. 15A, 15B, and 15C are views for explaining a method of manufacturing a hybrid printed circuit board 1' according to one or more embodiments of the disclosure.

First, as illustrated in FIG. 15A, solder paste 50 is applied to the upper surface of the first terminal pattern 16 of the first printed circuit board 10 and the upper surface of the second terminal pattern 16' of the second printed circuit board 10'. At this time, the solder paste 50 may be applied to the portions of the printed circuits formed on the upper copper foil layers 12 and 12 of the first and second printed circuit boards 10 and 10' on which the surface mount device SMD will be attached.

Next, as illustrated in FIG. 15B, the connection board 40 is placed on the solder paste 50 applied to the first terminal pattern 16 and the second terminal pattern 16'. In this case, the connection pattern 41 of the connection board 40 is brought into contact with the solder paste 50 of the first terminal pattern 16 and the second terminal pattern 16'. At this time, the surface mount device may be placed on the solder paste applied to the attachment portion of the surface mount device of each of the first and second printed circuit boards 10 and 10'.

In this state, a reflow process is performed on the hybrid printed circuit board 1'.

Then, as illustrated in FIG. 15C, the connection board 40 is connected to the first terminal pattern 16 of the first printed circuit board 10 and the second terminal pattern 16' of the second printed circuit board 10' by the solder paste 50. Accordingly, the first printed circuit board 10 and the second printed circuit board 10' may be electrically connected to each other by the connection board 40. At this time, the solder paste 50 between the connection pattern 41 and the first and second terminal patterns 16 and 16' is exposed to the outside. Therefore, by visually checking the exposed solder paste 50, it may be confirmed whether the connection pattern 41 and the first and second terminal patterns 16 and 16' are well connected.

In addition, when the reflow process is performed, the surface mount devices may be attached to the printed circuits of the first and second printed circuit boards 10 and 10' by the solder paste 50.

In the above description, the two printed circuit boards 10 and 10', that is, the first printed circuit board 10 and the second printed circuit board 10', disposed on the upper surface of the insulating substrate 20 are electrically connected using the connection board 40. However, as another example, the method of connecting two printed circuit boards 10 and 10' using the connection board 40 as described above may be applied to connecting two printed circuit boards 10 and 10' without the insulating substrate 20.

For example, the connection board 40 described above may be used to connect a timing controller (T-con) board and a power board of a display apparatus. At this time, the T-con board may be formed of a double-sided printed circuit board 10, and the power board may be formed of a single-sided printed circuit board 10'.

Hereinafter, with reference to FIGS. 16, 17, and 18, the thickness of the power board 100 using the hybrid printed circuit board 1 according to one or more embodiments of the disclosure will be compared with the thickness of the power board 101 according to the prior art.

FIG. 16 is a view illustrating a power board 100 using a hybrid printed circuit board 1 according to one or more embodiments of the disclosure disposed on a metal chassis 200.

Referring to FIG. 16, a power board 100 according to one or more embodiments of the disclosure includes a hybrid printed circuit board 1.

The hybrid printed circuit board 1 includes a double-sided printed circuit board 10 and an insulating substrate 20.

The printed circuit board 10 includes a base plate 11, an upper copper foil layer 12, and a lower copper foil layer 13. Surface mount devices 70 and 80 are disposed on the upper copper foil layer 12 of the printed circuit board 10. The surface mount devices 70 and 80 may be fixed to the upper surface of the printed circuit board 10 using surface mount technology.

The printed circuit board 10 includes a through hole 15. The surface mount device 70 having a high height may be accommodated in the through hole 15. In other words, the lower portion of the body 72 of the surface mount device 70 may be accommodated in the through hole 15. At this time, the leads 71 of the surface mount device 70 may be fixed to the printed circuit formed on the upper surface of the printed circuit board 10 by soldering. For example, the surface mount device 70 having a high height may be a transformer.

The surface mount device 80 having a low height may be disposed in an area where there is no through hole 15. At this time, the leads 81 of the surface mount device 80 may be fixed to the printed circuit formed on the upper surface of the printed circuit board 10 by soldering.

The power board 100 may be disposed on a metal chassis 200. In other words, the power board 100 may be disposed on the upper surface of the metal chassis 200. At this time, the lower surface of the insulating substrate 20 of the hybrid printed circuit board 1 may contact the upper surface of the metal chassis 200.

In this case, the thickness T of the hybrid printed circuit board 1 may satisfy safety standards (e.g., IEC62368-1). For example, the thickness of the hybrid printed circuit board 1 may be 1.8 mm. At this time, the thickness T1 of the printed circuit board 10 is about 1.2 mm, and the thickness T2 of the insulating substrate 20 is about 0.6 mm. The thickness T2 of the insulating substrate 20 includes the thickness of the adhesive member 30.

Therefore, in the power board 100 using the hybrid printed circuit board 1 according to this embodiment, the height from the upper surface of the metal chassis 200 to the upper surface of the hybrid printed circuit board 1 (hereinafter referred to as the installation height of the power board) is 1.8 mm, so it may satisfy safety standards.

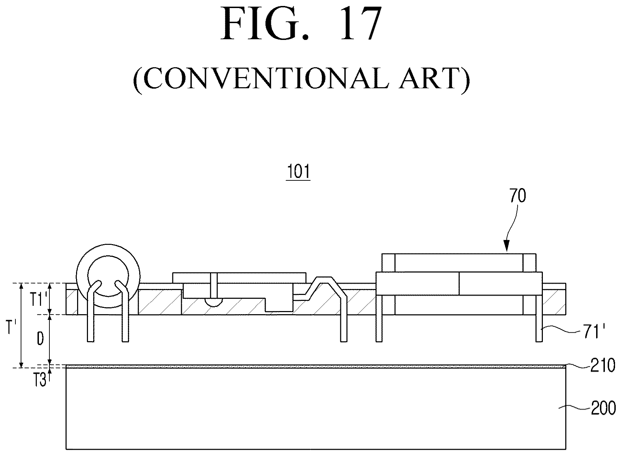

FIG. 17 is a view illustrating a power board 101 according to the prior art disposed in a metal chassis 200.

Referring to FIG. 17, the power board 101 according to the prior art includes a printed circuit board 110 according to the prior art.

A plurality of lead holes are formed in the printed circuit board 110 according to the prior art. Leads 71 of electronic components 70 are inserted into the plurality of lead holes and protrude below the printed circuit board 110.

An insulating sheet 210 is disposed on the upper surface of the metal chassis 200. The thickness of the insulating sheet 210 is at least 0.5 mm.

The power board 101 is disposed at a certain distance from the insulating sheet 210 so that the leads 71' of the electronic components 70 do not contact the insulating sheet 210. To this end, the distance D between the printed circuit board 110 and the insulating sheet 210 needs to be maintained at 2.5 mm.

The thickness T1' of the printed circuit board 110 is 1.6 mm. The thickness of the printed circuit board 110 used in the power board 101 must be 1.6 mm or more.

Therefore, in the power board 101 using the printed circuit board 110 according to the prior art, the height from the upper surface of the metal chassis 200 to the upper surface of the printed circuit board 110, that is, the installation height T' of the power board 101 is 4.6 mm, so it may meet safety standards. Here, T' = T1' + D + T3 = 1.6 mm + 2.5 mm + 0.5 mm = 4.6 mm.

However, because the installation height T' of the power board 101 according to the prior art is 4.6 mm, it is 2.8 mm higher than the installation height T of the power board 100 using the hybrid printed circuit board 1 according to one or more embodiments of the disclosure. Therefore, the power board 101 according to the prior art may have limitations in reducing the thickness of the display apparatus.

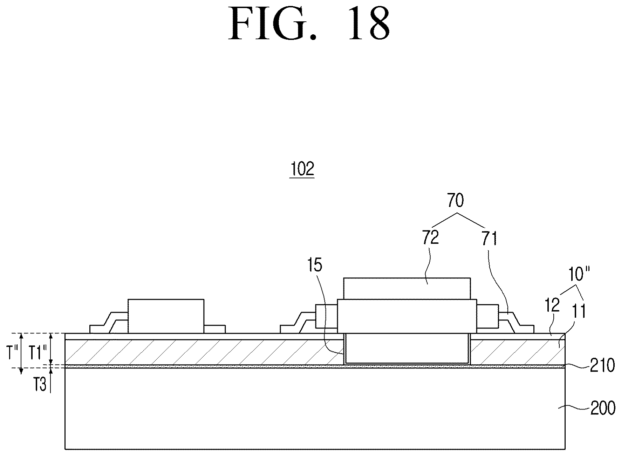

FIG. 18 is a view illustrating a power board 102 using an SMD printed circuit board 10" disposed on a metal chassis 200.

Referring to FIG. 18, the power board 102 includes an SMD printed circuit board 10".

The SMD printed circuit board 10" refers to a printed circuit board on which a surface mount device (SMD) 70 may be mounted.

The SMD printed circuit board 10" may be formed as a single-sided printed circuit board. That is, the SMD printed circuit board 10" includes a base plate 11 and a copper foil layer 12. The surface mount device 70 is disposed on the copper foil layer 12 of the SMD printed circuit board 10". The surface mount device 70 may be fixed to the upper surface of the SMD printed circuit board 10" using surface mounting technology.

The SMD printed circuit board 10" includes a through hole 15. The surface mount device 70 having a high height may be accommodated in the through hole 15. In other words, the lower portion of the body 72 of the surface mount device 70 may be accommodated in the through hole 15. At this time, the leads 71 of the surface mount device 70 may be fixed to the printed circuit formed on the upper surface of the SMD printed circuit board 10" by soldering.

An insulating sheet 210 is disposed on the upper surface of the metal chassis 200. The thickness of the insulating sheet 210 is at least 0.5 mm.

The power board 102 is disposed on the upper side of the insulating sheet 210. That is, the power board 102 is disposed on the upper surface of the insulating sheet 210. At this time, the lower surface of the SMD printed circuit board 10", that is, the lower surface of the base plate 11, is in contact with the insulating sheet 210.

The thickness T1" of the SMD printed circuit board 10" is 1.6 mm. The thickness of the SMD printed circuit board 10" used in the power board 102 must be 1.6 mm or more.

Therefore, in the power board 102 using the SMD printed circuit board 10", the height from the upper surface of the metal chassis 200 to the upper surface of the SMD printed circuit board 10", that is, the installation height T" of the power board 102 is 2.1 mm, so it may meet safety standards. Here, T" = T1" + T3 = 1.6 mm + 0.5 mm = 2.1 mm.

Because the installation height T" of the power board 102 using the SMD printed circuit board 10" is 2.1 mm, it is 0.3 mm higher than the installation height T of the power board 100 using the hybrid printed circuit board 1 according to one or more embodiments of the disclosure.

In the hybrid printed circuit board 1 according to one or more embodiments of the disclosure, the insulating substrate 20 has the same or similar strength as the base plate 11 of the printed circuit board 10, so the sum of the thickness of the printed circuit board 10 and the thickness of the insulating substrate 20 becomes the thickness of the hybrid printed circuit board 1. Therefore, the hybrid printed circuit board 1 according to one or more embodiments of the disclosure may satisfy the thickness of 1.6 mm, which is the thickness of the printed circuit board required for the power boards 100, 101, and 102.

However, because the strength of the insulating sheet 210 is less than the strength of the base plate 11 of the printed circuit board 10, the SMD printed circuit board 10" may not be made thin. Therefore, the power board 102 using the SMD printed circuit board 10" and the insulating sheet 210 may not be formed to be thinner than the power board 100 using the hybrid printed circuit board 1 according to one or more embodiments of the disclosure.

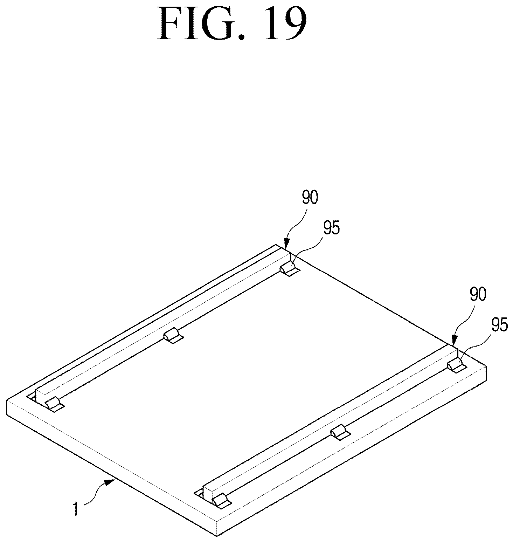

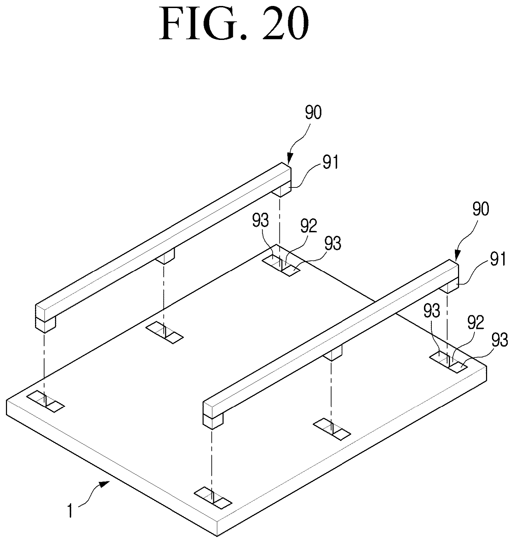

FIG. 19 is a perspective view illustrating a state in which a bending prevention reinforcement member 90 is disposed on a hybrid printed circuit board 1 according to one or more embodiments of the disclosure. FIG. 20 is a perspective view illustrating a state in which a bending prevention reinforcement member 90 is separated from a hybrid printed circuit board 1 according to one or more embodiments of the disclosure.

Referring to FIGS. 19 and 20, a hybrid printed circuit board 1 according to one or more embodiments of the disclosure may include a bending prevention reinforcement member 90. Two bending prevention reinforcement members 90 may be disposed on the upper surface of the hybrid printed circuit board 1. The bending prevention reinforcement member 90 may include a reinforcing material formed to prevent or suppress bending of the printed circuit board 1.

The bending prevention reinforcement member 90 is formed as a bar-shaped flat plate with a narrow width and a long length. A plurality of fixing protrusions 91 may be formed on a lower surface of the bending prevention reinforcement member 90. In the case of this embodiment, the bending prevention reinforcement member 90 includes three fixing protrusions 91. Copper foil layers may be provided on both side surfaces of the bending prevention reinforcement member 90 above the plurality of fixing protrusions 91.

A plurality of fixing holes 92 are formed on the upper surface of the hybrid printed circuit board 1. The plurality of fixing holes 92 are formed in numbers corresponding to the plurality of fixing protrusions 91. In the case of this embodiment, because the bending prevention reinforcement member 90 includes three fixing protrusions 91, three fixing holes 92 are formed on the upper surface of the hybrid printed circuit board 1.

Soldering spots 93 may be provided on both sides of each of the plurality of fixing holes 92. The soldering spots 93 are provided so that the bending prevention reinforcement member 90 may be fixed by soldering.

Accordingly, the plurality of fixing protrusions 91 of the bending prevention reinforcement member 90 are inserted into the plurality of fixing holes 92 on the upper surface of the hybrid printed circuit board 1, and then the plurality of soldering spots 93 and the bending prevention reinforcement member 90 are connected by soldering, so that the bending prevention reinforcement member 90 is fixed to the upper surface of the hybrid printed circuit board 1.

When the bending prevention reinforcement member 90 is disposed on the hybrid printed circuit board 1, the strength of the hybrid printed circuit board 1 is improved. Therefore, when the thickness of the hybrid printed circuit board 1 is thin, the strength of the hybrid printed circuit board 1 may be maintained.

While the disclosure has been illustrated and described with reference to various example embodiments thereof, it will be understood that the various example embodiments are intended to be illustrative, not limiting. It will be understood by those skilled in the art that various changes in form and details may be made therein without departing from the true spirit and full scope of the disclosure, including the appended claims and their equivalents.

## Claims

1. A hybrid printed circuit board comprising:
an insulating substrate;
a printed circuit board disposed on an upper surface of the insulating substrate and including at least one through hole in which a surface mount device is accommodated; and
an adhesive member provided between the insulating substrate and the printed circuit board.

2. The hybrid printed circuit board of claim 1, wherein
the adhesive member is formed of no-flow prepreg or bonding sheet.

3. The hybrid printed circuit board of claim 1, wherein
the insulating substrate is formed of any one of FR-1, FR-3, FR-4, CEM-1, and CEM-3.

4. The hybrid printed circuit board of claim 1, wherein
a thickness of the insulating substrate is at least 0.4 mm.

5. The hybrid printed circuit board of claim 1, wherein
the printed circuit board comprises:
a base plate; and
a copper foil layer formed on at least one of upper and lower surfaces of the base plate.

6. The hybrid printed circuit board of claim 5, wherein
the base plate of the printed circuit board is formed of any one of FR-1, FR-3, FR-4, CEM-1, and CEM-3.

7. The hybrid printed circuit board of claim 1, wherein
the printed circuit board comprises a base plate and a copper foil layer provided on one surface of the base plate, and
wherein the insulating substrate is formed of a same insulating material as the base plate.

8. The hybrid printed circuit board of claim 1, wherein
the printed circuit board comprises a base plate and a copper foil layer provided on one surface of the base plate, and
wherein the insulating substrate is formed of an insulating material different from the base plate.

9. The hybrid printed circuit board of claim 1, wherein
the printed circuit board comprises a base plate and an upper copper foil layer and a lower copper foil layer provided on upper and lower surfaces of the base plate, and
wherein the insulating substrate is formed of a same insulating material as the base plate.

10. The hybrid printed circuit board of claim 1, wherein
the printed circuit board comprises a base plate and an upper copper foil layer and a lower copper foil layer provided on upper and lower surfaces of the base plate, and
wherein the insulating substrate is formed of an insulating material different from the base plate.

11. The hybrid printed circuit board of claim 1, wherein
the printed circuit board includes a first printed circuit board and a second printed circuit board that are electrically connected to each other.

12. The hybrid printed circuit board of claim 11, wherein
the first printed circuit board includes a first terminal pattern formed on its upper surface,
wherein the second printed circuit board includes a second terminal pattern formed on its upper surface to correspond to the first terminal pattern, and
wherein the printed circuit board further includes a connection board that is disposed on upper surfaces of the first terminal pattern and the second terminal pattern and electrically connects the first terminal pattern and the second terminal pattern.

13. The hybrid printed circuit board of claim 12, wherein
the connection board includes a connection pattern formed to connect the first terminal pattern and the second terminal pattern.

14. The hybrid printed circuit board of claim 11, wherein
the first printed circuit board is formed as a double-sided printed circuit board, and the second printed circuit board is formed as a single-sided printed circuit board.

15. The hybrid printed circuit board of claim 1, further comprising:
a bending prevention reinforcement member disposed on the upper surface of the printed circuit board.
